# EUROPÄISCHE PATENTSCHRIFT

(11) **EP 1 959 298 B1**
(45) Veröffentlichungstag und Bekanntmachung des Hinweises auf die Patenterteilung: **16.06.2010**
(21) Anmeldenummer: 08002496.1
(22) Anmeldetag: 12.02.2008
(51) Int. Cl.: G03F 7/00, B01L 3/00

(54) **Verfahren zur Strukturierung einer Schicht auf einem Substrat**
Method for structuring a layer onto a substrate
Procédé destiné à la structuration d'une couche sur un substrat

(30) Priorität: 16.02.2007 DE 102007007719
(43) Veröffentlichungstag der Anmeldung: 20.08.2008
(73) Patentinhaber: Karlsruher Institut für Technologie, 76131 Karlsruhe (DE)
(72) Erfinder: Schimmel, Thomas, 76131 Karlsruhe (DE); Pancera-Montero, Sabrina, 67061 Ludwigshafen (DE); Gliemann, Hartmut, 76307 Spielberg (DE)

(56) Entgegenhaltungen:
- EP-A- 1 333 324
- KYUNG HYUN CHOI ET AL: "Excimer laser micromachining for 3D microstructure" JOURNAL OF MATERIALS PROCESSING TECHNOLOGY ELSEVIER SWITZERLAND, Bd. 149, Nr. 1-3, 10. Juni 2004 (2004-06-10), Seiten 561-566, XP002531836 ISSN: 0924-0136
- DANIEL HAEFLIGER ET AL: "Three-dimensional microfabrication in negative resist using printed masks; 3D microfabrication using printed masks" JOURNAL OF MICROMECHANICS & MICROENGINEERING, INSTITUTE OF PHYSICS PUBLISHING, BRISTOL, GB, Bd. 16, Nr. 5, 1. Mai 2006 (2006-05-01), Seiten 951-957, XP020104988 ISSN: 0960-1317

## Beschreibung

Die Erfindung betrifft ein Verfahren zur Strukturierung einer Schicht, die aus mindestens einem Polymer besteht und Additive enthalten kann, auf einem Substrat.

In strahlungsinduzierten lithographischen Verfahren werden durch eine lokal selektive Bestrahlung von ausgewählten Bereichen Belichtungsmuster auf einer Oberflächenschicht erzeugt. Die weitere Prozessierung ist dadurch möglich, dass sich die bestrahlten und die nicht bestrahlten Bereiche der Schicht hinsichtlich ihres Verhaltens gegenüber mindestens einem Lösungsmittel voneinander unterscheiden. In Folge der unterschiedlichen Löslichkeit der bestrahlten und der nicht bestrahlten Bereiche gegenüber einer Anzahl von Lösungsmitteln lassen sich entweder die bestrahlten (Positivresist) oder die nicht bestrahlten Bereiche (Negativresist) der Oberflächenschicht selektiv lösen, wodurch die gewünschten Strukturen (Topologien) auf der Oberfläche entstehen.

Aus dem Stand der Technik ist bekannt, die lokal selektive Bestrahlung entweder durch *direktes Schreiben,* wobei ein fokussierter Laser- oder Elektronenstrahl über die zu strukturierende Oberflächenschicht geführt wird, oder durch *Maskenlithographie,* bei der eine Maske auf die zu strukturierende Oberflächenschicht gelegt und die Maske dann großflächig so bestrahlt wird, dass nur an den nicht abgedeckten Bereichen in der Oberflächenschicht eine Modifizierung des Materials stattfindet, auszuführen. Unabhängig vom gewählten Verfahren wird durch die lokal selektive Bestrahlung das Ausgangsmaterial der Oberflächenschichten (photo-)chemisch modifiziert oder durch die Strahlung vollständig abgetragen.

Die Belichtung von Schichten aus Photolacken mit ultraviolettem Licht (UV) durch Masken zur Erzeugung von Strukturen ist bekannt und wird insbesondere zur Herstellung von Strukturen auf Halbleiteroberflächen oder zur Herstellung von Masken für die Lithographie eingesetzt. Ebenso lassen sich mikrofluidische Systeme durch UV-Belichtung eines Substrats, das mit dem Photoresist-Lack SU-8 beschichtetet ist, durch eine Maske herstellen. In der optischen Polymertechnologie werden UV-lithographische Verfahren eingesetzt, um auf Substraten Polymerbahnen zu erzeugen, die als Lichtwellenleiter dienen.

Aus S. Asakura, A. Hozumi, T. Yamaguchi, A. Fuwa, Thin Solid Films, 500, S. 237, 2006, ist die Möglichkeit der Strukturierung von Polymethylmethacrylat (PMMA) durch UV-Lithographie und ihre Anwendung als Negativ- oder Positivresist bekannt.

In A. Hozumi, T. Masuda, K. Hayashi, H. Sugimura, O. Takai, T. Kameyama, Langmuir 18, Seite 9022, 2002 und A. Hozumi, H. Inagaki, T. Kameyama, J. Coll. Int. Sci. 278, S. 383, 2004 wird am Beispiel von PMMA und Polystyrol (PS) gezeigt, dass die Bestrahlung des Polymers mit UV zu dessen Abbau führt.

Weiterhin bekannt ist der Einsatz von Interferenztechnik bei der Bestrahlung lichtempfindlicher Schichten zur Erzeugung strukturierter Oberflächen. Die Bestrahlung eines Gitters mit Laserlicht erzeugt hinter dem Gitter ein Interferenzmuster, das auf die lichtempfindliche Schicht projiziert wird. Die durch die Maxima der Interferenz beleuchteten Bereiche auf der Schicht erfahren dabei eine photochemische Modifizierung.

Die Lithographie mit Masken erzeugt Strukturen, deren laterale Dimensionen genau so groß sind wie die Dimensionen der Maskenstrukturen. Nachteilig hieran ist, dass insbesondere die Herstellung von Masken für Strukturen unterhalb von 100 nm einen immer höheren Aufwand erfordert. Zudem erfordert jede Änderung der Strukturgröße die Herstellung einer neuen Maske.

Bei Einsatz der Laser- oder Elektronenstrahllithographie für das *direkte Schreiben* muss jede Position der Oberfläche, an der eine Struktur erzeugt werden soll, mit dem betreffenden Strahl individuell angefahren werden. Diese Voraussetzung verhindert die parallele Herstellung einer großen Zahl von Strukturen, so dass sich diese Verfahren nur zur Produktion von individuell strukturierten Substraten in geringer Stückzahl eignen. Zudem schränken lithographische Schreibverfahren die laterale Größe der strukturierbaren Oberfläche ein. Außerdem erfordern die herkömmlichen Verfahren einen hohen apparativen Aufwand wie z.B. Lichtausschluss bei Lichtlithographie oder Ultrahochvakuum in der Elektronenstrahllithographie.

Die mit herkömmlichen lithographischen Verfahren hergestellten Strukturen sind auf ihren Oberflächen nicht chemisch funktionalisiert und müssen in einem gesonderten Schritt lokal selektiv chemisch funktionalisiert werden. Unter *chemischer* Funk*tionalisierung* wird hierbei die Terminierung der Strukturoberfläche mit funktionellen bzw. chemisch reaktiven Gruppen verstanden, die sich dazu einsetzen lassen, die relevanten physikalischen Oberflächeneigenschaften wie hydrophob/hydrophil, polar/unpolar, fluoreszierend/nicht fluoreszierend usw. durch weitere chemische Reaktionen die Eigenschaften der Strukturoberflächen zu beeinflussen.

Die WO 2006/056905 A2, die EP 0 810 477 A2 und die US 6,114, 082 A offenbaren jeweils ein Strukturierungsverfahren einer Schicht auf einem Substrat, worin eine Photolackschicht auf ein Substrat aufgebracht und mittels elektromagnetischer Strahlung durch eine Maske hindurch strukturiert belichtet wird. Der Photolack besitzt Eigenschaft, bei Unterschreitung einer unteren Grenzdosis und bei Überschreitung einer oberen Grenzdosis für die belichtende Strahlung die Löslichkeitseigenschaften in einem Entwickler zu ändern, d.h. löslich bzw. unlöslich zu werden. Lediglich diejenigen Bereiche innerhalb des Photolacks, die mit einer mittleren Dosis oberhalb der unteren Grenzdosis und unterhalb der oberen Grenzdosis beaufschlagt wurden, bleiben unlöslich bzw. löslich. Bei entsprechend gewählter Dosis werden die unmittelbar unter dem Randbereich der Maske liegenden Bereiche der Photolackschicht mit einer mittleren Dosis beaufschlagt und sind daher im Entwickler unlöslich bzw. löslich, so dass sich in diesen Bereichen nach der Entwicklung Wände bzw. Gräben ausbilden.

T. Lippert, J. Wei, A. Wokaun, N. Hoogen und O. Nuyken, Development and structuring of combined positive-negative/ negative-positive resists using laser ablation as positive dry etching technique, Macromol. Mater. Eng., Band 283 (2000), S. 140-143, und die US 4,414, 059 offenbaren Strukturierungsverfahren einer Schicht auf einem Substrat, worin eine Negativ-Photolackschicht mittels elektromagnetischer Strahlung einer Wellenlänge durch eine Maske hindurch strukturiert wird, bei der eine Vernetzung der belichteten Bereiche der Photolackschicht erfolgt. Bei der anschließenden Entwicklung werden die unbelichteten Bereiche entfernt und die negativen Strukturen gebildet. In einem weiteren Schritt werden vernetzte Bereiche der Photolackschicht mittels elektromagnetischer Strahlung einer kürzeren Wellenlänge belichtet, bei der eine Photoablation in den betreffenden Bereichen der Photolackschicht auftritt.

Ausgehend hiervon ist es die Aufgabe der vorliegenden Erfindung, ein Verfahren zur Strukturierung einer Schicht, die aus mindestens einem Polymer besteht und Additive enthalten kann, auf einem Substrat vorzuschlagen, das die genannten Nachteile und Einschränkungen nicht aufweist.

Insbesondere besteht die Aufgabe der Erfindung darin, ein Verfahren dieser Art bereit zu stellen, das bei einer niedrigen Zahl an Arbeitsschritten und bei geringem technischen und zeitlichen Aufwand die Herstellung von Strukturen mit Dimensionen von 1 nm bis 1000 µm und deren gleichzeitige chemische Funktionalisierung ermöglicht.

Eine weitere Aufgabe der Erfindung besteht darin, ein Verfahren dieser Art bereit zu stellen, das eine hohe Flexibilität sowohl im Hinblick auf Form und Material der Oberfläche als auch in Bezug auf die geometrischen Parameter (laterale und vertikale Ausdehnung; Abstände der Strukturen) zulässt.

Diese Aufgabe wird durch die Schritte des Anspruchs 1 gelöst. Die Unteransprüche beschreiben vorteilhafte Ausgestaltungen der Erfindung.

Das erfindungsgemäße Verfahren umfasst die im Folgenden im Einzelnen erläuterten Schritte a) bis c).

Gemäß Schritt a) wird zunächst eine Anordnung bereitgestellt, die
- ein Substrat und
- eine auf der Oberfläche des Substrats aufgebrachte Schicht umfasst, die aus einem Polymer oder mehreren Polymeren besteht, die darüber hinaus auch Additive enthalten kann und die bevorzugt, aber nicht notwendigerweise eben ist. Als Additiv eignen sich bevorzugt Substanzen, die eine wellenlängenselektive Bestrahlung und Modifizierung der Schicht ermöglichen.

Die Oberflächenschicht wird nicht vollständig, sondern nur über ausgewählten Bereichen mit einer Maske abgedeckt. In einer bevorzugten Ausgestaltung ist die Maske so angeordnet, dass während der Bestrahlung gemäß Schritt b) ein Spalt zwischen der Schicht und der Maske verbleibt.

Die Materialien, aus denen Schicht und Maske bestehen, werden so gewählt, dass das Polymer oder zumindest eines der Polymere, aus denen die Schicht besteht, durch Strahlung mindestens einer Frequenz aus dem elektromagnetischen Spektrum, vorzugsweise durch ultraviolette (UV) Strahlung, insbesondere mit einer Wellenlänge kleiner 350 nm, oder durch eine Teilchen-Strahlung modifizierbar ist, während die Maske für die gewählte Strahlung undurchlässig ist.

Als Substrat eignet sich eine Vielzahl von Materialien, solange sich diese in dem unter Schritt c) näher erläuterten Lösungsmittel nicht auflösen. Hierzu gehören metallische oder halbleitende Oberflächen sowie organische Materialien.

Anschließend wird die Anordnung gemäß Schritt b) durch die gewählte Strahlung beaufschlagt. Hierbei wird die Strahlendosis so eingestellt, dass die Schicht in Abhängigkeit von der Abdeckung durch die Maske das folgende Verhalten zeigt, wobei sich die Strahlendosis aus der Intensität der Strahlungsquelle, dem Abstand zwischen der Strahlungsquelle und der Oberfläche der Polymerschicht sowie der Dauer der Bestrahlung ergibt:
- In denjenigen Bereichen, in denen die Maske die Polymerschicht *nicht* abdeckt, trägt die Strahlung einen ersten Teil des Polymers ab, wobei der Abtrag an Material aus der Polymerschicht von der Höhe der in die Polymerschicht eingebrachten Strahlendosis abhängt.
- An den Rändern derjenigen Bereiche, in denen die Maske die Polymerschicht nicht abdeckt, aber noch unterhalb der Maske, wird ebenfalls ein Teil des Polymers abgetragen.
- An den Rändern der Bereiche, in denen die Strahlung die Polymerschicht abträgt, erfolgt z.B. durch photoinduzierte radikalische Reaktion eine Modifikation des zweiten Teils des Polymers durch Quervernetzung der Polymerketten untereinander. Die Vernetzung der Polymerketten findet jedoch höchstens bis zu einer Tiefe von wenigen Mikrometern statt, so dass sowohl die Oberflächen als auch das Kernmaterial der durch die Maske abgedeckten Bereiche der Polymerschicht chemisch unmodifiziert bleiben. Dieser Vorgang ist Ursache für die verringerte Löslichkeit des modifizierten Polymers in einem Lösungsmittel, das das unmodifizierte Polymer löst, bis hin zu einer vollständigen Unlöslichkeit des modifizierten Polymers.
- In den übrigen Bereichen bleibt das Polymer unverändert.

Während der Bestrahlung werden auf diese Weise kontinuierlich Seitenwände freigelegt, die dann ebenfalls der Strahlung ausgesetzt werden. So treten im Seitenwandbereich grundsätzlich gleichzeitig eine Vernetzung der Polymerketten und ein horizontaler Materialabtrag auf.

In einer bevorzugten Ausgestaltung findet die Bestrahlung der Anordnung unter oxidativen Bedingungen, besonders bevorzugt unter Normalbedingungen in Luft, statt. Durch den auf diese Weise bereitgestellten Sauerstoff werden die Oberflächen der bestrahlten Bereiche zusätzlich oxidiert und stehen so für weitere chemische Reaktionen zur Verfügung. Durch diesen Vorgang wird ein Teil des Polymers nicht nur *modifiziert,* sondern darüber hinaus im selben Schritt auch *funktionalisiert.*

Weiterhin werden durch die Menge des zur Verfügung stehenden Sauerstoffs der Materialabtrag und damit die Tiefe der Kavitäten sowie die Höhe der Wände eingestellt. Die zur Verfügung stehende Sauerstoffmenge kann durch die Höhe der Maske oder durch den Anteil des Sauerstoffgehalts im Reaktionsgas eingestellt werden. Die maximal erreichbare Tiefe der Kavitäten und die maximal erreichbaren Höhen der Wände sind durch Wahl der Dicke der ursprünglichen Polymerschicht vorgegeben.

In einer alternativen Ausgestaltung findet die Bestrahlung der Anordnung unter Schutzgas (Stickstoff, Argon) statt, um eine Oxidation der Schicht während der Bestrahlung zu vermeiden.

Anschließend wird gemäß Schritt c) die Maske von der bestrahlten Anordnung entfernt und die nach der Entfernung der Maske verbleibende Anordnung mit einem Lösungsmittel behandelt. Das Lösungsmittel führt zur selektiven Auflösung von Teilen der nicht durch die Strahlung bereits abgetragenen Polymerschicht.

Es wird ein Lösungsmittel eingesetzt, das den folgenden Bedingungen genügt:
- Es löst das Substrat nicht auf.
- Es löst den zweiten Teil des Polymers, d.h. denjenigen Teil des Polymers, der durch die Bestrahlung in Schritt b) modifiziert wurde, höchstens teilweise auf.
- Es löst denjenigen Teil des Polymers, der nicht bestrahlt wurde oder der durch die Bestrahlung während Schritt b) *nicht* modifiziert wurde, nur insoweit auf, als sich dieser unterhalb der Maske befand.

Durch die Behandlung des Substrates mit einem derartigen Lösungsmittel bilden sich daher Wände aus, die eine Dicke von wenigen Mikrometern besitzen. Diese Wände bestehen aus dem zweiten Teil des Polymers, der durch die Bestrahlung in Schritt b) modifiziert wurde, und dem sich hierunter befindlichen nicht modifizierten Teil des Polymers.

In einer bevorzugten Ausgestaltung wird die Anordnung sofort nach der Bestrahlung, während oder nach der Behandlung mit dem Lösungsmittel zusätzlich mit einer Spülflüssigkeit gespült wird, die weitere Bereiche aus dem zweiten Teil der Schicht auflöst. Bei geeigneter Wahl der Spülflüssigkeit wird so die Oberfläche der erfindungsgemäß hergestellten Struktur funktionalisiert. In einer besonders bevorzugten Ausgestaltung wird das Lösungsmittel gleichzeitig als Spülflüssigkeit eingesetzt.

Der strahlungsinduzierte Materialabtrag eignet sich zur Strukturierung und zur Modifizierung von Polymeroberflächen. Die erfindungsgemäß hergestellten Wände bilden Strukturen, z.B. Begrenzungen für (Mikro-) Kavitäten und Kanäle mit Dimensionen von 1 nm bis 1000 µm, deren genaue Form von der Höhe der Oberflächenschicht, der Strahlendosis, dem eingesetzten Lösungsmittel bzw. der Spülflüssigkeit abhängen.

Mit dem erfindungsgemäßen Verfahren hergestellte Strukturen eignen sich als Resists für Oberflächen-Ätzprozesse. Weiterhin eigenen sich Strukturen dieser Art zur spezifischen Adhäsion von biologischen und nicht-biologischen Molekülen oder von Partikeln und Zellen aller Art.

In einer bevorzugten Ausgestaltung werden die mit dem erfindungsgemäßen Verfahren hergestellten Strukturen direkt als Stempeloberfläche zum direkten Stempeln (Hoch- oder Tiefstempeln) auf Oberflächen verwendet.

In einer besonderen Ausgestaltung werden die Zwischenräume der auf einer leitfähigen Oberfläche erzeugten Strukturen durch galvanische Abscheidungsprozesse mit anderen Materialien wie z.B. Metallen oder leitfähigen Polymeren gefüllt und für Replikationszwecke verwendet.

Die Bedeutung von Verfahren zur Oberflächenstrukturierung und zur chemischen Oberflächenfunktionalisierung nimmt sowohl im Bereich der regenerativen Medizin und der künstlichen Organe als auch im Bereich der Biologie *(Lab-on-Chip* Anwendungen) zu. Hierbei spielt die chemische Funktionalisierung mittels UV-Belichtung eine wichtige Rolle, die bereits zur Herstellung von funktionalisierten Oberflächen z.B. für die Zelladhäsion eingesetzt wird. Das Beispiel der Zelladhäsion macht deutlich, dass Adhäsionsvorgänge an Oberflächen nicht nur die geeignete chemische Funktionalisierung der Oberfläche erfordern, sondern dass auch geometrische Faktoren wie Größe und Verteilung der funktionalisierten Strukturen auf der Oberfläche entscheidenden Einfluss auf die Effizienz der Adhäsion besitzen.

Das erfindungsgemäße Verfahren weist insbesondere die im Folgenden erwähnten Vorteile auf.
- Das erfindungsgemäße Verfahren zeichnet sich dadurch aus, dass mit derselben Maske lediglich durch Wahl der Strahlendosis und Variation der Bestrahlungs-Parameter Strukturen hergestellt werden können, deren Dimensionen um den Faktor 1-100 kleiner sind als die der Maskenstrukturen. Zudem lassen sich die Dimensionen der Strukturen sehr einfach durch Variation der Bestrahlungs-Parameter ändern. So lassen sich mit Maskenstrukturen im Mikrometerbereich Strukturen im Submikrometerbereich herstellen. Der Einsatz von Masken erlaubt die gleichzeitige, parallele Herstellung einer Vielzahl von Strukturen.
- Bei der Bestrahlung unter oxidativen Bedingungen finden Strukturbildung und Funktionalisierung der Schicht gleichzeitig statt. Die aufwändige selektive chemische Funktionalisierung der Strukturoberflächen nach der Herstellung entfällt.
- Das erfindungsgemäße Verfahren ist kostengünstig, da sämtliche Arbeitsschritte unter Normalbedingungen (an Luft unter Normaldruck bei Raumtemperatur) durchgeführt werden können. Als Strahlungsquelle eignet sich u. a. Quecksilberdampflampe.

Die Erfindung wird im Folgenden anhand von Ausführungsbeispielen und den Figuren näher erläutert. Die Figuren zeigen:
- **Fig. 1**: **a) bis c)** Schematische Darstellung der Schritte eines Strukturierungsverfahrens aus dem Stand der Technik.
- **Fig. 2**: **a) bis c)** Schematische Darstellung der Schritte des erfindungsgemäßen Verfahrens.
- **Fig. 3**: AFM Aufnahmen von Ausschnitten aus Strukturen, die mit dem erfindungsgemäßen Verfahren hergestellt wurden:
**a)** Bestrahlungszeit 1 Minute; Abstand Lampe - Glasplatte 17 cm; Maske hat direkten Kontakt zur Oberfläche der Polymerschicht; Ausschnitt 100 µm x 100 µm;
**b)** Bestrahlungszeit 20 Minuten; Abstand Lampe - Glasplatte 17 cm; Maske hat direkten Kontakt zur Oberfläche der Polymerschicht; Ausschnitt 100 µm x 100 µm;
**c)** Bestrahlungszeit 20 Minuten; Abstand Lampe - Glasplatte 17 cm; Abstand Maske - Oberfläche der Polymerschicht einige Mikrometer; Ausschnitt 50 µm x 50 µm.

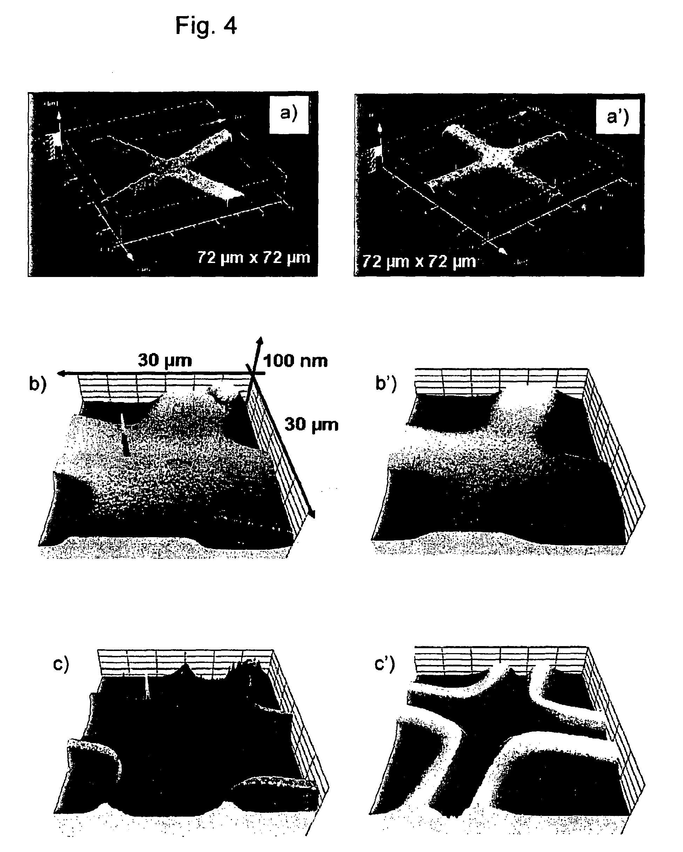

- **Fig. 4**: **a) und a')** Konfokal-mikroskopische Aufnahmen von Transmissionselektronenmikrokopie-Netzen mit verschiedener Geometrie als Masken;
**b) und b')** AFM-Aufnahmen von Strukturen vor der Spülung mit Cyclohexan;
**c) und c')** AFM-Aufnahmen der Strukturen aus **Fig. 4 b)** bzw. **b')** nach der Spülung mit Cyclohexan.

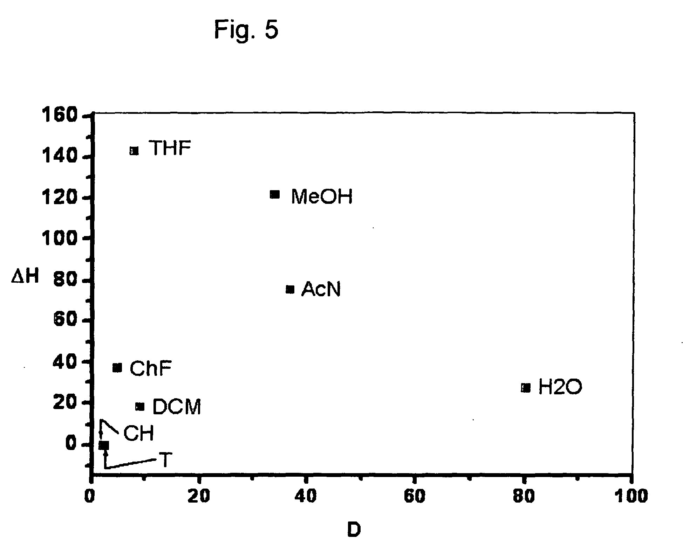

- **Fig. 5**: Schichtdickendifferenz ΔH erfindungsgemäß hergestellter Strukturen vor und nach dem Spülen mit Spülflüssigkeit als Funktion der Dielektrizitätskonstanten D der Spülflüssigkeit Cyclohexan (CH), Toluol (T), Dichlormethan (DCM), Chloroform (ChF), Tetrahydrofuran (THF), Methanol (MeOH), Acetonitril (AcN) bzw. Wasser (H₂O).

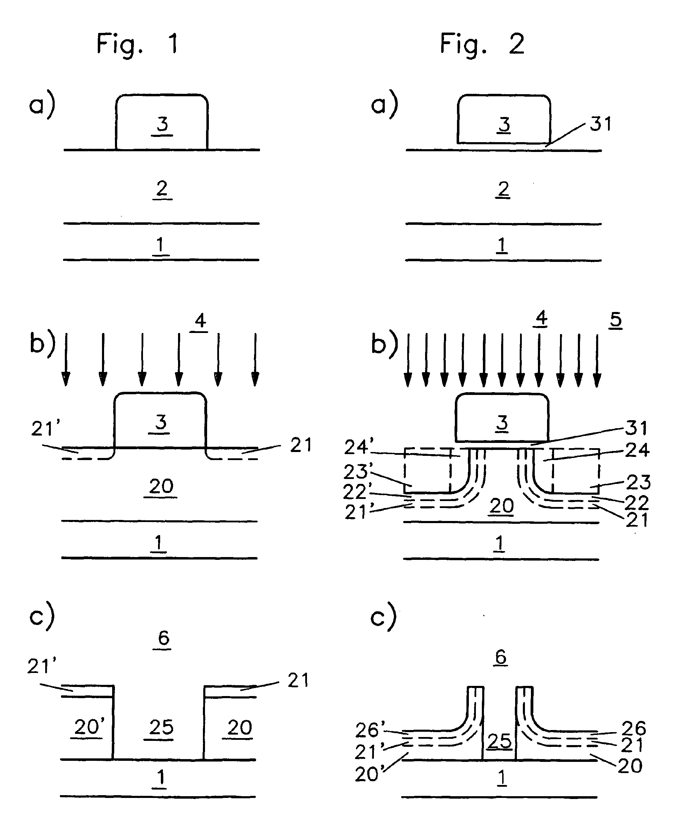

In **Fig. 1** sind schematisch die Schritte eines aus dem Stand der Technik üblichen Verfahrens zur Herstellung von Strukturen in einer Schicht, die aus mindestens einem Polymer besteht und Additive enthalten kann, auf einem Substrat dargestellt. Auf ein Substrat 1 wird gemäß **Fig. 1a****)** eine Schicht **2** aus einem UV-vernetzenden und mittels UV-Strahlung abbaubaren Polymer aufgebracht und ohne Spalt mit einer Maske versehen. Die Bestrahlung gemäß **Fig. 1b**) erfolgt unter Schutzgas mit einer so geringen Strahlendosis, dass lediglich in einer oberflächennahen Schicht **21, 21'** außerhalb der Maske **3** eine Vernetzung der Polymere eintritt. Nach Behandeln mit einem Lösungsmittel wird die sich unterhalb der Maske **3** befindliche unbestrahlte Schicht **25** abgelöst, während die weiteren unbestrahlten Schichten **20, 20'** sowie die oberflächennahen Schichten **21, 21'** stehen bleiben.

In **Fig. 2** sind schematisch die Schritte des erfindungsgemäßen Verfahrens zur Herstellung von Strukturen in einer Schicht **2** auf einem Substrat **1** am Beispiel von Polystyrol dargestellt.

Auf ein Substrat **1** wird zunächst eine Lösung des UV-vernetzenden und mittels UV-Strahlung abbaubaren Polymers Polystyrol in einem Lösungsmittel mittels Schleuder-, Tropf oder Tauchtechnik aufgebracht. Nach dem Verdunsten des Lösungsmittels bildet sich gemäß **Fig. 2 a)** eine Polymerschicht **2** auf der Oberfläche des Substrats 1 aus. Dann wird eine Bestrahlungsmaske **3** auf die Oberfläche der Polymerschicht **2** gelegt und mit einer Quarzglasplatte abgedeckt, wobei ein Spalt **31** zwischen der Bestrahlungsmaske 3 und der Polymerschicht **2** verbleiben kann.

Anschließend wird gemäß **Fig. 2 b)** die Anordnung aus Substrat **1** und Polymerschicht 2 von oben mit UV-Strahlung bestrahlt. Als Strahlungsquelle eignet sich eine Quecksilberdampflampe, deren Ausdehnung wesentlich größer als die der Bestrahlungsmaske **3** ist, um eine gleichmäßige Ausleuchtung der Bestrahlungsmaske **3** zu erhalten. Bei größeren Masken wird die Anordnung mechanisch unter der Lampe hin und her bewegt, um eine gleichmäßige Bestrahlung der Oberfläche zu erzielen.

Durch die Bestrahlung **4** wird in den Bereichen, in denen die Bestrahlungsmaske **3** die Polymerschicht **2** nicht abdeckt, ein erster Teil **23, 23'** des Polymers abgetragen, wenn unter oxidativen Bedingungen **5** bestrahlt wird. An den Rändern der Bereiche, in denen die Maske **3** die Polymerschicht **2** nicht abdeckt, aber noch unterhalb der Maske **3,** wird ebenfalls ein Teil **24, 24'** des Polymers abgetragen. An den Rändern der Bereiche, in denen die Strahlung die Polymerschicht abträgt, erfolgt durch photoinduzierte radikalische Reaktion eine Modifikation eines zweiten Teils **21, 21'** des Polymers durch Quervernetzung der Polymerketten untereinander. Findet die Bestrahlung **4** unter oxidativen Bedingungen 5 statt, so oxidiert Sauerstoff die Oberflächen **22, 22'** der bestrahlten Bereiche zusätzlich und steht für weitere chemische Reaktionen (Funktionalisierung) zur Verfügung. In den übrigen Bereichen **20** bleibt das Polymer unverändert.

Schließlich wird, wie in **Fig. 2c****)** dargestellt, die Bestrahlungsmaske **3** von der bestrahlten Anordnung abgenommen und die verbleibende, bereits bestrahlte Anordnung der Behandlung **6** mit einem Lösungsmittel unterzogen. Das Lösungsmittel ist dabei so ausgewählt, dass es das Substrat **1** nicht auflöst, dass es den zweiten Teil **21, 21', 22, 22'** der Schicht nur teilweise auflöst und den nicht modifizierten Teil **25** der Schicht, insoweit sich dieser unterhalb der Bestrahlungsmaske **3** befand, auflöst. Auf diese Weise bilden sich, wie in **Fig. 2 c)** angedeutet, chemisch funktionalisierte polymere Wände, zwischen denen sich Kavitäten oder Kanäle ausbilden. Höhe und Breite dieser Wände (Wandungen) hängen von der Strahlendosis und der Dicke der ursprünglichen Polymerschicht **2** ab.

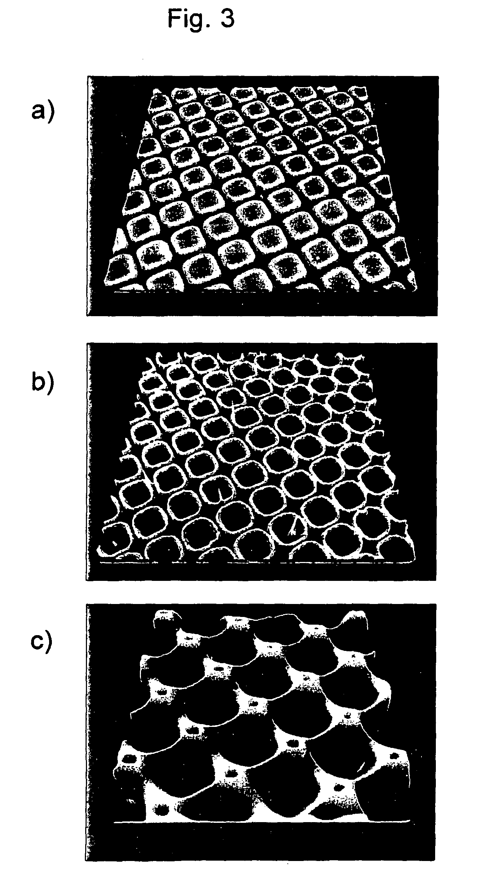

In **Fig. 3** ist der Einfluss der Strahlendosis und des Abstands zwischen der Maske **5** und der Polymerschicht **2** auf die nach dem Entwicklungsprozess erhaltenen Strukturen dargestellt.

**Fig. 3 a)** zeigt einen 100 µm x 100 µm großen Ausschnitt aus einer ca. 100 nm hohen Struktur, die mit dem erfindungsgemäßen Verfahren hergestellt wurde. Hierzu wurden 20 µL einer Lösung aus 25 mg Polystyrol (100 000 g/mol) in 1 ml Toluol durch 30 s langes Spinschleudern bei 3000 U/Min. auf einen 1 cm² großen Silizium(100)-Wafer, der als Substrat **1** diente, aufgebracht, der mittels einem Snow-Jet gereinigt worden war. Anschließend wurde ein Kupfernetz mit 800 Maschen/cm auf die gebildete Polystyrolschicht **2** gelegt, mittels einer Quarzglasplatte abgedeckt und dann 1 Minute lang mit UV-Licht aus einer 500 W Quecksilberdampflampe bei einem Abstand von 17 cm zwischen Lampe und Glasplatte bestrahlt. Glasplatte und Netz wurden danach entfernt und mit Cyclohexan gespült. Aus **Fig. 2 a)** ist deutlich erkennbar, dass in den mittleren Breichen der erhabenen Strukturen der Materialabtrag noch zu gering war, um eine Bildung von Kavitäten zu erhalten.

**Fig. 3 b)** zeigt einen weiteren 100 µm x 100 µm großen Ausschnitt aus einer ca. 100 nm hohen Struktur, die mit dem erfindungsgemäßen Verfahren hergestellt wurde. Die Herstellung erfolgte wie in dem in **Fig. 3 a)** dargestellten Beispiel, wobei hier die Bestrahlungszeit mit UV-Licht aus einer 500 W Quecksilberdampflampe 20 Minuten betrug. Die von oben offenen Mikrokavitäten sind durch etwa 100 nm hohe Wände begrenzt und durch Mikrokanäle voneinander getrennt. Die Kavitäten entstanden durch das unter photolytische Abtragen von Polystyrol in denjenigen Bereichen, die nicht von der Maske abgedeckt waren. Die Kanäle wurden durch das Weglösen der chemisch nicht modifizierten, d.h. der durch die Maske abgedeckten Bereiche der Polystyrolschicht durch Behandlung mit Cyclohexan erzeugt. Die Höhen der Wandungen und damit die Tiefe der Kanäle und Kavitäten sind dabei durch die Höhe der aufgebrachten Polymerschicht begrenzt.

**Fig. 3c****)** zeigt einen weiteren 50 µm x 50 µm großen Ausschnitt aus derselben ca. 100 nm hohen Struktur, wie in **Fig. 3b****)** dargestellt, jedoch an einer Stelle, an der die Bestrahlungsmaske **3** einen Abstand **31** von einigen µm zur Polymeroberfläche **2** aufwies. Hier sind die Wandungen benachbarter Kavitäten aufgrund des geringen Abstands der Maske **5** von der Oberfläche des Polymers **2** ineinander verschmolzen.

Die in **Fig. 3c****)** abgebildete Struktur zeigt beispielhaft miteinander verschmolzene Wände. Die Verschmelzung ist jedoch in diesem Fall auf die oberflächennahe Vernetzung der unter der Bestrahlungsmaske **3** befindlichen Bereiche der Polymerschicht **2** zwischen den Wänden zurückzuführen. Aufgrund des Spaltes **31** zwischen der Bestrahlungsmaske **3** und der Polymerschicht **2** konnte die vernetzende UV-Strahlung in diesen hierdurch entstandenen Zwischenraum eindringen und eine Modifizierung der Oberfläche der Polymerschicht **2** hervorrufen.

Ein Vergleich zeigt, dass sich die Tiefe der Kavitäten durch die Strahlendosis einstellen lässt. Je höher die Dosis, umso mehr Material wird abgetragen, wie der direkte Vergleich von **Fig. 3b****)** zu **Fig. 3a****)** zeigt. Der Zwischenraum zwischen zwei gegenüber liegenden Wandungen wird durch die Strahlendosis geformt: Die Dosis wird hierbei so gewählt, dass sich gegenüber liegende Wände schließlich berühren und zu einer einzigen Wand verschmelzen, deren Breite wiederum von der Strahlungsdosis abhängt.

**Fig. 4** demonstriert den Einfluss der Geometrie der Bestrahlungsmaske **3** auf das erfindungsgemäße Verfahren. **Fig. 4a****)** und **a')** zeigen Aufnahmen der planaren bzw. der abgerundeten Seite der als Masken verwendeten Transmissionselektronenmikrokopie-Netze (TEM-Netze). Je nach dem, ob die flache Seite **(****Fig. 3 a)** **bis c))** oder die abgerundete Seite **(****Fig. 3** **a')** bis c')) während der Belichtung Kontakt zur Polymerschicht hat, ergeben sich verschiedene Geometrien, die sich in Bezug auf Kanalbreite und Dicke der Wände unterscheiden.

Die Herstellung der in **Fig. 4** gezeigten Strukturen erfolgte wie in dem in **Fig. 3 a)** dargestellten Beispiel, wobei ein Kupfernetz mit 80 Maschen/cm entweder mit der flachen Seite **(****Fig. 4 a)** **bis c))** oder mit der abgerundeten Seite **(****Fig. 4** **a') bis c'))** auf die entstandene Schicht aus Polystyrol gelegt wurde.

Die UV-Bestrahlung erfolgt über 10 Minuten bei einem Abstand zwischen Lampe und Glasplatte von 17 cm. Danach wurden Glasplatte und Netz entfernt und die AFM-Topographieaufnahmen gemäß **Fig. 4 b)** und **b')** an den ca. 100 nm hohen Strukturen vorgenommen. Anschließend wurden die Proben mit Cyclohexan gespült und an den identischen Probenstellen wie in **Fig. 4 b)** und b') erneut AFM-Topographieaufnahmen vorgenommen, die nun in **Fig. 3 c)** **und c')** zu sehen sind. Die in den **Fig. 4 b), c), b')** und **c')** dargestellten Ausschnitte umfassen 30 µm x 30 µm.

**Fig. 5** demonstriert den Einfluss der Art der Spülflüssigkeit, insbesondere ihrer Dielektrizitätskonstante und der Polarität ihrer Moleküle auf die resultierende Schichtdicke. Dargestellt ist die Schichtdickendifferenz ΔH von UV-bestrahlten Polymeroberflächen vor und nach dem Spülen mit Spülflüssigkeiten, die unterschiedliche Dielektrizitätskonstanten D aufweisen. Hierbei wurden die Spülflüssigkeiten Cyclohexan (CH), Toluol (T), Dichlormethan (DCM), Chloroform (ChF), Tetrahydrofuran (THF), Methanol (MeOH), Acetonitril (AcN) und Wasser (H₂O) eingesetzt.

### Liste der Bezugszeichen

- **1**: Substrat
- **2**: Schicht aus unbehandeltem Polymer (mit/ohne Additive)
- **20, 20'**: Nicht entferntes unbehandeltes Polymer neben der Maske
- **21, 21'**: Schicht aus vernetztem Polymer
- **22, 22'**: Schicht aus oxidiertem Polymer
- **23, 23'**: Durch strahlungsinduzierten Materialabtrag entferntes Polymer neben der Maske
- **24, 24'**: Durch strahlungsinduzierten Materialabtrag entferntes Polymer unterhalb der Maske
- **25**: Entferntes unbehandeltes Polymer unterhalb der Maske
- **26, 26'**: Mit Lösungsmittel bzw. Spülflüssigkeit behandelte Schicht 21, 21' aus oxidiertem Polymer
- **3**: (Bestrahlungs-)Maske
- **31**: Abstand (Spalt) zwischen Maske 3 und Schicht 2
- **4**: Bestrahlung (bevorzugt UV-Strahlung)
- **5**: Oxidation in oxidativer Atmosphäre
- **6**: Behandlung mit Lösungsmittel

## Patentansprüche

1. Verfahren zur Strukturierung einer Schicht auf einem Substrat, das die folgenden Schritte umfasst:
a) Bereitstellen einer Anordnung, die ein Substrat (1) und eine hierauf aufgebrachte Schicht (2) umfasst, wobei die Schicht (2) aus mindestens einem Polymer besteht und Additive enthalten kann, und
Abdecken von ausgewählten Bereichen der Schicht (2) durch eine Maske (3), wobei mindestens eines der Polymere der Schicht so gewählt ist, dass es durch elektromagnetische Strahlung oder Teilchen-Strahlung modifizierbar ist, für die die Maske (3) undurchlässig ist,
b) Beaufschlagen der Anordnung mit der Strahlung, deren Dosis derart gewählt wird, dass die Strahlung einen ersten Teil (23, 23', 24, 24') der Schicht, den die Maske (3) nicht bedeckt (23, 23') oder der, unterhalb der Maske (3) liegend, hieran angrenzt (24, 24') vollständig abträgt und einen zweiten Teil (21, 21', 22, 22') der Schicht, der an den ersten Teil angrenzt, modifiziert,
c) Entfernen der Maske (3) von der bestrahlten Anordnung und Behandeln der bestrahlten Anordnung mit einem Lösungsmittel, das das Substrat (1) nicht auflöst,
den zweiten Teil (21, 21', 22, 22') der Schicht höchstens teilweise auflöst und den nicht modifizierten Teil (25) der Schicht, soweit sich dieser unterhalb der Maske (3) befand, auflöst, wodurch Wände stehen bleiben.

2. Verfahren nach Anspruch 1, wobei die Beaufschlagung der Anordnung mit der Strahlung unter oxidativen Bedingungen erfolgt.

3. Verfahren nach Anspruch 2, wobei die Beaufschlagung der Anordnung mit der Strahlung unter Normalbedingungen an Luft erfolgt.

4. Verfahren nach einem der Ansprüche 1 bis 3, wobei die Beaufschlagung der Anordnung mit ultravioletter Strahlung erfolgt.

5. Verfahren nach einem der Ansprüche 1 bis 4, wobei während Schritt b) zwischen der Schicht (2) und der Maske (3) ein Spalt (31) verbleibt.

6. Verfahren nach einem der Ansprüche 1 bis 5, wobei die Anordnung vor, nach oder während Schritt c) zusätzlich mit einer Spülflüssigkeit gespült wird, die weitere Bereiche aus dem zweiten Teil (21, 21', 22, 22') der Schicht auflöst.

7. Verfahren nach Anspruch 6, wobei das Lösungsmittel gleichzeitig als Spülflüssigkeit eingesetzt wird.

8. Verfahren nach einem der Ansprüche 1 bis 7, mit dem Strukturen mit Abmessungen von 1 nm bis 1000 µm hergestellt werden.

## Claims

1. Method for structuring a layer on a substrate, said method comprising the following steps:
a) preparing an arrangement that comprises a substrate (1) and a layer (2) applied to said substrate, wherein the layer (2) is produced from at least one polymer and can include additives, and
covering selected regions of the layer (2) by a mask (3), wherein at least one of the polymers of the layer is selected such that it is modifiable through electromagnetic radiation or particle radiation, to which the mask (3) is impermeable,
b) exposing the arrangement to radiation, the dose of which is selected in such a manner that the radiation completely removes a first part (23, 23', 24, 24') of the layer that the mask (3) does not cover (23, 23') or which, lying under the mask (3), adjoins hereto (24, 24'), and modifies a second part (21, 21', 22, 22') of the layer that abuts against the first part,
c) removing the mask (3) from the irradiated arrangement and treating the irradiated arrangement with a solvent, which does not dissolve the substrate (1), at the most partially dissolves the second part (21, 21', 22, 22') of the layer and dissolves the non-modified part (25) of the layer, insofar as it was situated underneath the mask (3), walls thereby remaining.

2. Method according to Claim 1, wherein the exposure of the arrangement to the radiation is effected under oxidative conditions.

3. Method according to Claim 2, wherein the exposure of the arrangement to the radiation is effected under normal conditions in air.

4. Method according to one of Claims 1 to 4, wherein the exposure of the arrangement is effected with ultraviolet radiation.

5. Method according to one of Claims 1 to 4, wherein during step b) a gap (31) remains between the layer (2) and the mask (3).

6. Method according to one of claims 1 to 4, wherein prior to, after or during step c), the arrangement is flushed additionally with a flushing liquid, which dissolves further regions from the second part (21, 21', 22, 22') of the layer.

7. Method according to Claim 6, wherein the solvent is used as flushing liquid at the same time.

8. Method according to one of claims 1 to 7, by means of which structures with dimensions from 1 nm to 1000 µm are produced.

## Revendications

1. Procédé de structuration d'une couche d'un substrat comprenant les étapes suivantes :
a) on fournit un dispositif comprenant un substrat (1) portant une couche (2),
- la couche (2) étant composée d'au moins un polymère et elle peut contenir des additifs, et
- on recouvre des zones sélectionnées de la couche (2) à l'aide d'un masque (3), au moins l'un des polymères de la couche étant choisi pour être modifié par un rayonnement électromagnétique ou un rayonnement de particules, pour lequel le masque (3) est imperméable,
b) on applique au dispositif un rayonnement dont la dose est sélectionnée pour que le rayonnement enlève complètement une première partie (23, 23', 24, 24') de la couche qui n'est pas couverte (23, 23') par le masque (3) ou enlève complètement la couche adjacente (24, 24') sous le masque (3) et modifie une seconde partie (21, 21', 22, 22') de la couche adjacente à la première partie,
c) on enlève le masque (3) du dispositif exposé et on traite le dispositif exposé avec un solvant qui ne dissout pas le substrat (1), qui dissout au plus partiellement la seconde partie (21, 21', 22, 22') de la couche et qui dissout la partie non modifiée (25) de la couche dans la mesure où celle-ci se trouve sous le masque (3) de manière à laisser des parois.

2. Procédé selon la revendication 1,
selon lequel
on applique au dispositif un rayonnement dans des conditions oxydantes.

3. Procédé selon la revendication 2,
selon lequel
on sollicite le dispositif avec le rayonnement dans des conditions normales, à l'air ambiant.

4. Procédé selon l'une des revendications 1 à 3,
selon lequel
on applique au dispositif un rayonnement ultraviolet.

5. Procédé selon l'une des revendications 1 à 4,
selon lequel
pendant l'étape b), il subsiste un intervalle (31) entre la couche (2) et le masque (3).

6. Procédé selon l'une des revendications 1 à 5,
selon lequel
on rince le dispositif avec un liquide de rinçage avant, après ou pendant l'étape c), ce liquide dissolvant d'autres zones de la seconde partie (21, 21', 22, 22') de la couche.

7. Procédé selon la revendication 6,
selon lequel
on utilise le solvant en même temps que le liquide de rinçage.

8. Procédé selon l'une des revendications 1 à 7,
selon lequel
on réalise des structures dont les dimensions sont comprises entre 1 nm jusqu'à 1000 µm.
